# EUROPEAN PATENT SPECIFICATION

(11) **EP 2 156 560 B1**
(45) Date of publication and mention of the grant of the patent: **23.05.2018**
(21) Application number: 08735909.7
(22) Date of filing: 07.04.2008
(51) Int. Cl.: H02M 3/07, H03L 7/089

(54) **CHARGE PUMP CMOS CIRCUIT**
LADUNGSPUMPEN-CMOS-SCHALTUNG
CIRCUIT CMOS DE POMPE DE CHARGE

(30) Priority: 05.04.2007 DE 102007016523
(43) Date of publication of application: 24.02.2010
(73) Proprietor: TEXAS INSTRUMENTS DEUTSCHLAND GMBH, 85356 Freising (DE)
(72) Inventor: RUCK, Bernhard Wolfgang, 85354 Freising (DE); GERBER, Johannes, 85716 Unterschleissheim (DE)
(74) Representative: Zeller, Andreas
(86) International application number: PCT/EP2008/054177
(87) International publication number: WO 2008/122632

(56) References cited:
- GB-A- 2 356 751
- US-A- 5 473 283
- US-A- 6 104 771
- US-A- 6 160 432

## Description

This generally relates to CMOS charge pump circuits; and, more particularly, to a pre-bias mechanism for charge pumps in clock control applications.

### BACKGROUND

Clock control applications generally require a charge pump controlled by a digital clock signal, for example in regulation of the duty cycle of a crystal oscillator in an ultra-low power microcontroller circuit. The document US 6,104,771 shows a PLL circuit comprising a charge pump circuit that typically comprises diode-connected MOS transistors and a current source. The charge pump circuit is controlled by the output clock signal of the PLL circuit. When a charge pump is controlled by a clock signal, the charge pump switches between a positive and a negative current controlled by the clock signal. Switching of the full output current causes a larger than required voltage change in diode connected MOS transistors used in current mirror operational amplifiers in the charge pump circuit. This increases the delay of the charge pump.

### SUMMARY

The invention provides a charge pump CMOS circuit as defined in present claim 1 and including, inter alia, a differential input stage with two parallel circuit branches. Each of the parallel circuit branches has a diode connected MOS transistor connected in series with a complementary input MOS transistor. The parallel circuit branches have a common tail current source. The diode-connected MOS transistors each have their gate/drain node connected to a current source. This provides a pre-bias scheme, which avoids complete discharge of the diode-connected MOS transistors during switching, therefore reducing the delay in charging up the voltage nodes in the driver.

Preferably, each of the parallel circuit branches has an associated current mirror stage. One of the current mirror stages can be a single-ended output stage.

### BRIEF DESCRIPTION OF THE DRAWINGS

Example embodiments are described below with reference to accompanying drawings, wherein:
FIG. 1 illustrates a charge pump CMOS circuit according to an example embodiment the invention; and
FIG. 2 illustrates the clock signals applied to the inputs of the example charge pump CMOS circuit.

### DETAILED DESCRIPTION OF EXAMPLE EMBODIMENTS

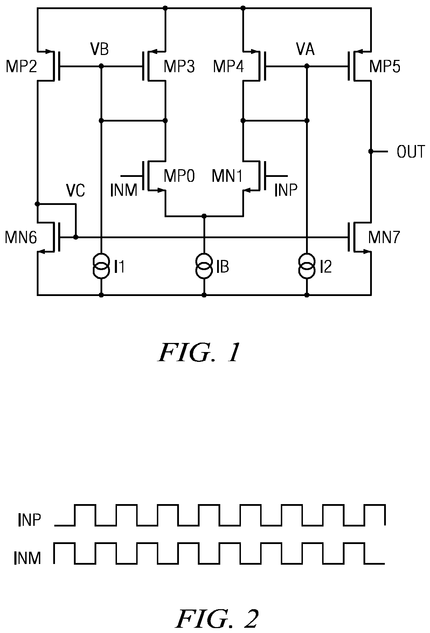

FIG. 1 shows a charge pump CMOS circuit, which is basically a current mirror operational transconductance amplifier (OTA). The circuit includes an N-channel MOS transistor MN0 having a source terminal connected to a source terminal of another N-channel MOS transistor MN1. Gate terminals of transistors MN0 and MN1 receive respective differential input signals so that the transistors MN0 and MN1 are differential input stages. The drain terminal of the transistor MN0 is connected to the drain terminal of a P-channel MOS transistor MP3. The drain terminal of the transistor MN1 is connected to the drain terminal of a P-channel MOS transistor MP4. The transistor pairs MN0 and MP3, and MN1 and MP4 form parallel circuit branches. Transistors MP3 and MP4 are diode connected and have interconnected source terminals. The connection of the gate and drain terminals of the transistor MP3 forms a voltage node VB. The connection of the gate and drain terminals of the transistor MP4 forms a voltage node VA. The source terminal of the transistor MP3 is also connected to the source terminal of another P-channel MOS transistor MP2. The source terminal of the transistor MP4 is connected to the source terminal of a P-channel MOS transistor MP5. Thus the source terminals of all the transistors MP2-MP5 are interconnected. The transistor pairs MP2 and MP6, and MP5 and MP7 form current mirror stages associated with each of the two parallel branches formed by the transistors MN0 and MN3; and MP4 and MN1, respectively. Each current mirror stage is amplifies the signal output from each of the branches by a factor depending on the actual physical size of the transistors MP2 and MP3 and MP5 and MP4.

The drain terminal of the transistor MP2 is interconnected with the drain terminal of an N-channel MOS transistor MN6. The drain terminal of the transistor MP5 is connected to the drain terminal of another N-channel MOS transistor MN7. The transistor pairs MP2 and MP3, MP4 and MP5, and MN6 and MN7, respectively have interconnected gate terminals. There is also an interconnection between the gate terminal and the drain terminal of the transistor MN6. The gate terminals of the transistors MN0 and MN1 receive respective input voltage signals Inm and Inp.

A current source Ib is connected between a node interconnecting the source terminals of the transistors MN0 and MN1 and a node interconnecting the source terminals of the transistors MN6 and MN7 so that the two parallel circuit branches have a common tail current source. A current source I1 is connected to the node Vb interconnecting the gate and drain terminals of the transistor MP3, the drain terminal of the transistor MN0 and the gate terminal of the transistor MP2. The current source I1 is also connected to the node interconnecting the source terminals of the transistors MN6 and MN7. A current source 12 is connected to the node Va interconnecting the source terminals of the transistors MN6 and MN7 and a node interconnecting the gate and drain terminals of the transistor MP4, the drain terminal of the transistor MN1 and the gate terminal of the transistor MP5. The current sources I1 and I2 provide respective bias currents to the nodes Vb and Va. The output node Out of the driver is provided at a node interconnecting the drain terminals of the transistors MP5 and MN7. Thus the current mirror stage comprising the transistors MP5 and MN7 is a single-ended output stage. An interconnection of the gate and drain terminals of the transistor MN6 forms a voltage node Vc.

In operation, differential input signals Inp and Inm are applied to the respective gates of the transistors MN0 and MN1. These input signals are illustrated in FIG. 2. The voltage node Vb is biased by the current source I1 and the voltage node Va is biased by the current source I2. The bias currents I1 and I2 cancel each other at the output so that they introduce no error to the output signal. The averaged output current from the driver then depends on the duty cycle of the input signals Inm and Inp.

The voltage nodes Va, Vb and Vc do not discharge fully when the input signals Inm and Inp to the corresponding transistors MN0 and MN1 are switched from high to low due to the current sources I1 and I2. Therefore the charge pump driver has a reduced switching delay. For example, if the input signal Inm applied to the gate of the transistor MN0 is at its maximum value and then switches to zero for the next cycle, this causes a large change in voltage of the voltage node Vb because the transistor MP3 discharges completely. This introduces a large delay because the voltage node Vb must be fully charged again when the input signal Inm switches back to high. However, because the node Vb is permanently charged via current source I1, the time required to charge the node Vb to its maximum voltage is reduced.

Furthermore, the presence of the current sources I1 and I2 means that the current generated by the current source Ib can be lower, while still keeping the switching time of the driver constant.

Those skilled in the art will appreciate that the described implementations are merely representative examples, and that many other embodiments are possible without departing from the scope of the invention, as defined by the appended claims.

## Claims

1. A charge pump CMOS circuit for use in an oscillator, comprising:
a first diode-connected MOS transistor (MP3) having a source connected to a first common node and a drain and gate connected together (Vb);
a first input MOS transistor (MN0) having a drain connected to the common drain and gate of said first diode-connected MOS transistor (Vb), a source connected to a second common node and a gate receiving a first differential input signal (INM); a second diode-connected MOS transistor (MP4) having a source connected to said first common node and a drain and gate connected together (Va);
a second input MOS transistor (MN1) having a drain connected to the common drain and gate of said second diode-connected MOS transistor (Va), a source connected to said second common node and a gate receiving a second differential input signal (INP); a first current source (Ib) connected between said second common node and a third common node;
a second current source (I1) connected between said common drain and gate of said first diode-connected MOS transistor and said third common node;
a third current source (I2) connected between said common drain and gate of said second diode-connected MOS transistor and said third common node;
a first current mirror circuit including
a first current mirror MOS transistor (MP2) having a source connected to said first common node, a gate connected to the common drain and gate (Vb) of said first diode-connected MOS transistor (MP3) and a drain, and
a second current mirror MOS transistor (MN6) having a drain connected to said drain of said first current mirror transistor (MP2), a gate connected to said drain and a source connected to said third common node; and
a second current mirror circuit including
a third current mirror MOS transistor (MP5) having a source connected to said first common node, a gate connected to the common drain and gate (Va) of said second diode-connected MOS transistor (MP4) and a drain,
a fourth current mirror MOS transistor (MN7) having a drain connected to said drain of said third current mirror transistor (MP5), a gate connected to the common drain and gate of said second current mirror MOS transistor (MN6) and a source connected to said third common node, and
an output terminal connected to said drain of said third current mirror MOS transistor (MP5) and said drain of said fourth current mirror MOS transistor (MN7).

2. The charge pump CMOS circuit of Claim 1, wherein:
said first and second diode-connected MOS transistors (MP3, MP4) are P-channel MOS transistors.

3. The charge pump CMOS circuit of Claim 1 or Claim 2, wherein:
said first and second input MOS transistors (MN0, MN1) are N-channel MOS transistors.

4. The charge pump CMOS circuit of any one of Claims 1 to 3, wherein:
said first and third current mirror MOS transistors (MP2, MP5) are P-channel MOS transistors.

5. The charge pump CMOS circuit of any one of Claims 1 to 4, wherein:
said second and fourth current mirror MOS transistors (MN6, MN7) are N-channel MOS transistors.

## Patentansprüche

1. Ladungspumpen-CMOS-Schaltung zur Verwendung in einem Oszillator, umfassend:
einen ersten als Diode geschalteten MOS-Transistor (MP3) mit einer Source, die mit einem ersten gemeinsamen Knoten verbunden ist, und einem Drain und einem Gate, die miteinander verbunden sind (Vb);
einen ersten Eingangs-MOS-Transistor (MN0) mit einem Drain, der mit dem gemeinsamen Drain und Gate des ersten als Diode geschalteten MOS-Transistors (Vb) verbunden ist, mit einer Source, die mit einem zweiten gemeinsamen Knoten verbunden ist, und mit einem Gate, das ein erstes differentielles Eingangssignal (INM) empfängt;
einen zweiten als Diode geschalteten MOS-Transistor (MP4) mit einer Source, die mit dem ersten gemeinsamen Knoten verbunden ist, und mit einem Drain und einem Gate, die miteinander verbunden sind (Va);
einen zweiten Eingangs-MOS-Transistor (MN1) mit einem Drain, der mit dem gemeinsamen Drain und Gate des zweiten als Diode geschalteten MOS-Transistors (Va) verbunden ist, mit einer Source, die mit dem zweiten gemeinsamen Knoten verbunden ist, und mit einem Gate, das ein zweites differentielles Eingangssignal (INP) empfängt;
eine erste Stromquelle (Ib), die zwischen dem zweiten gemeinsamen Knoten und einen dritten gemeinsamen Knoten angeschlossen ist;
eine zweite Stromquelle (I1), die zwischen dem gemeinsamen Drain und Gate des ersten als Diode geschalteten MOS-Transistors und dem dritten gemeinsamen Knoten angeschlossen ist;
eine dritte Stromquelle (I2), die zwischen dem gemeinsamen Drain und Gate des zweiten als Diode geschalteten MOS-Transistors und dem dritten gemeinsamen Knoten angeschlossen ist;
eine erste Stromspiegelschaltung mit
einem ersten Stromspiegel-MOS-Transistor (MP2) mit einer Source, die mit dem ersten gemeinsamen Knoten verbunden ist, mit einem Gate, das mit dem gemeinsamen Drain und Gate (Vb) des ersten als Diode geschalteten MOS-Transistors (MP3) verbunden ist, und mit einem Drain und
einem zweiten Stromspiegel-MOS-Transistor (MN6) mit einem Drain, der mit dem Drain des ersten Stromspiegel-Transistors (MP2) verbunden ist, mit einem Gate, das mit dem Drain verbunden ist, und mit einer Source, die mit dem dritten gemeinsamen Knoten verbunden ist; und
eine zweite Stromspiegelschaltung mit
einem dritten Stromspiegel-MOS-Transistor (MP5) mit einer Source, die mit dem ersten gemeinsamen Knoten verbunden ist, mit einem Gate, das mit dem gemeinsamen Drain und Gate (Va) des zweiten als Diode geschalteten MOS-Transistors (MP4) verbunden ist, und mit einem Drain,
einem vierten Stromspiegel-MOS-Transistor (MN7) mit einem Drain, der mit dem Drain des dritten Stromspiegel-Transistors (MP5) verbunden ist, mit einem Gate, das mit dem gemeinsamen Drain und Gate des zweiten Stromspiegel-MOS-Transistors (MN6) verbunden ist, und mit einer Source, die mit dem dritten gemeinsamen Knoten verbunden ist, und
einem Ausgangsanschluss, der mit dem Drain des dritten Stromspiegel-MOS-Transistors (MP5) und dem Drain des vierten Stromspiegel-MOS-Transistors (MN7) verbunden ist.

2. Ladungspumpen-CMOS-Schaltung nach Anspruch 1, wobei:
der erste und der zweite als Diode geschaltete MOS-Transistor (MP3, MP4) P-Kanal-MOS-Transistoren sind.

3. Ladungspumpen-CMOS-Schaltung nach Anspruch 1 oder 2, wobei:
der erste und der zweite Eingangs-MOS-Transistor (MN0, MN1) N-Kanal-MOS-Transistoren sind.

4. Ladungspumpen-CMOS-Schaltung nach einem der Ansprüche 1 bis 3, wobei:
der erste und der dritte Stromspiegel-MOS-Transistor (MP2, MP5) P-Kanal-MOS-Transistoren sind.

5. Ladungspumpen-CMOS-Schaltung nach einem der Ansprüche 1 bis 4, wobei:
der zweite und der vierte Stromspiegel-MOS-Transistor (MN6, MN7) N-Kanal-MOS-Transistoren sind.

## Revendications

1. Circuit CMOS de pompage de charge à utiliser dans un oscillateur, comprenant :
un premier transistor MOS connecté à une diode (MP3) ayant une source connectée à un premier noeud commun et un drain et une grille connectés ensemble (Vb) ;
un premier transistor MOS d'entrée (MN0) ayant un drain connecté au drain et à la grille communs dudit premier transistor MOS connecté à une diode (Vb), une source connectée à un deuxième noeud commun et une grille recevant un premier signal d'entrée différentiel (INM) ;
un deuxième transistor MOS connecté à une diode (MP4) ayant une source connectée audit premier noeud commun et un drain et une grille connectés ensemble (Va) ;
un deuxième transistor MOS d'entrée (MN1) ayant un drain connecté au drain et à la grille communs dudit deuxième transistor MOS connecté à une diode (Va), une source connectée audit deuxième noeud commun et une grille recevant un deuxième signal d'entrée différentiel (INP) ;
une première source de courant (Ib) connectée entre ledit deuxième noeud commun et un troisième noeud commun ;
une deuxième source de courant (I1) connectée entre lesdits drain et grille communs dudit premier transistor MOS connecté à une diode et ledit troisième noeud commun ;
une troisième source de courant (I2) connectée entre lesdits drain et grille communs dudit deuxième transistor MOS connecté à une diode et ledit troisième noeud commun ;
un premier circuit miroir de courant comportant
un premier transistor MOS miroir de courant (MP2) ayant une source connectée audit premier noeud commun, une grille connectée au drain et à la grille communs (Vb) dudit premier transistor MOS connecté à une diode (MP3) et un drain, et
un deuxième transistor MOS miroir de courant (MN6) ayant un drain connecté audit drain dudit premier transistor miroir de courant (MP2), une grille connectée audit drain et une source connectée audit troisième noeud commun ; et
un deuxième circuit miroir de courant comportant
un troisième transistor MOS miroir de courant (MP5) ayant une source connectée audit premier noeud commun, une grille connectée au drain et à la grille communs (Va) dudit deuxième transistor MOS connecté à une diode (MP4) et un drain,
un quatrième transistor MOS miroir de courant (MN7) ayant un drain connecté audit drain dudit troisième transistor miroir de courant (MP5), une grille connectée au drain et à la grille communs dudit deuxième transistor MOS miroir de courant (MN6) et une source connectée audit troisième noeud commun, et
une borne de sortie connectée audit drain dudit troisième transistor MOS miroir de courant (MP5) et audit drain dudit quatrième transistor MOS miroir de courant (MN7).

2. Circuit CMOS de pompage de charge de la revendication 1, dans lequel :
lesdits premier et deuxième transistors MOS connectés à une diode (MP3, MP4) sont des transistors MOS à Canal P.

3. Circuit CMOS de pompage de charge de la revendication 1 ou la revendication 2, dans lequel :
lesdits premier et deuxième transistors MOS d'entrée (MN0, MN1) sont des transistors MOS à Canal N.

4. Circuit CMOS de pompage de charge de l'une quelconque des revendications 1 à 3, dans lequel :
lesdits premier et troisième transistors MOS miroirs de courant (MP2, MP5) sont des transistors MOS à Canal P.

5. Circuit CMOS de pompage de charge de l'une quelconque des revendications 1 à 4, dans lequel :
lesdits deuxième et quatrième transistors MOS miroirs de courant (MN6, MN7) sont des transistors MOS à Canal N.
